Europäisches Patentamt

European Patent Office

Office européen des brevets

(19)

(11) Veröffentlichungsnummer: **0 263 954**
**A1**

## (12) EUROPÄISCHE PATENTANMELDUNG

(21) Anmeldenummer: 87112668.6

(22) Anmeldetag: 31.08.87

(51) Int. Cl.⁴ **H01H 69/02**

(30) Priorität: 24.09.86 DE 3632413

(43) Veröffentlichungstag der Anmeldung:
20.04.88 Patentblatt 88/16

(84) Benannte Vertragsstaaten:
AT CH DE FR GB IT LI NL SE

(71) Anmelder: DEMETRON Gesellschaft für
Elektronik-Werkstoffe m.b.H.
Leipziger Strasse 10
D-6450 Hanau 1(DE)

(72) Erfinder: Böhm, Wolfgang, Dr.
Kronbergweg 2
D-8755 Alzenau(DE)
Erfinder: Malikowski, Willi
Brentanoplatz 11
D-8750 Aschaffenburg(DE)
Erfinder: Weise, Wolfgang, Dr.
Merianstrasse 40
D-6000 Frankfurt am Main(DE)

(74) Vertreter: Nowak, Gerhard
DEGUSSA AG Fachbereich Patente
Rodenbacher Chaussee Postfach 1345
D-6450 Hanau 1(DE)

(54) Verfahren zur Herstellung flinker Schmelzsicherungen.

(57) Flinke Schmelzsicherungen, insbesondere für elektronische Baugruppen, mit optimalen elektrischen Eigenschaften erhält man, wenn man dem Schmelzleiterwerkstoff 0,5 bis 10 Gew. % Titan, Zirkonium, Hafnium und/oder Beryllium zusetzt und entsprechende Formteile auf einer keramischen Unterlage aufschmilzt.

EP 0 263 954 A1

## Verfahren zur Herstellung flinker Schmelzsicherungen

Die Erfindung betrifft ein Verfahren zur Herstellung flinker Schmelzsicherungen, insbesondere für elektronische Baugruppen, bestehend aus einer keramischen Unterlage und einer leichtschmelzenden Metall-oder Legierungsschicht, durch Aufbringen eines Formteils aus diesem Metall bzw. Legierung auf die keramische Unterlage.

Schmelzsicherungen schützen elektrische Anlagen oder Geräte vor Überströmen. Der aktive Teil einer solchen Sicherung besteht aus einem draht- oder bandförmigen Schmelzleiter aus einem elektrisch gut leitenden metallischen Werkstoff mit relativ niedrigem Schmelzpunkt, der bei unzulässig hohen Strömen durchschmilzt. Meist besitzt der Schmelzleiter eine oder mehrere Engestellen, um das Durchschmelzen zu erleichtern.

Insbesondere zum Schutz elektronischer Bauteile oder Baugruppen werden Schmelzsicherungen eingesetzt, die im Überlastfall ebenfalls eine galvanische Trennung ermöglichen. Diese Sicherungen müssen, um ausreichenden Schutz zu gewährleisten, mit superflinker Charakteristik unterbrechen. Zudem ist eine kleine Baugröße erwünscht.

Flinke Sicherungen können durch eine entsprechende Auswahl der Schmelzleiterlegierung und die geometrische Ausbildung der Engestelle erzeugt werden.

Dies gelingt besonders gut, wenn bei Nennstrombetrieb die Verlustwärme gut abgeführt werden kann. Dadurch wird auch die thermische und elektrische Belastbarkeit pro Volumen verbessert. Schmelzleiter, die als Schicht auf einer keramischen Unterlage aufgebracht werden, erfüllen diese Bedingung besonders gut. Hierzu kommen ihre hohe mechanische Stabilität und Wechselfestigkeit. Bekannt sind aufgedampfte, aufgesputterte, durch thermische Zersetzung und galvanisch abgeschiedene oder durch Einbrennpräparate hergestellte Schichten.

So werden z.B. in der DE-OS 32 21 919 die Schmelzleiterschichten mittels Siebdruck auf die keramische Unterlagen aufgebracht. Diese bekannten Verfahren haben den Nachteil, daß die Aufbringverfahren für die Schmelzleiterschicht auf die Unterlage relativ aufwendig und daher teuer ist, daß meist keine definierten Legierungen herstellbar sind und daß insbesondere bei der Verwendung von Einbrennpasten Pastenbestandteile in der Schicht verbleiben und diese inhomogen machen.

Aus der DE-GM 78 26 855 ist eine Schmelzsicherung bekannt, bei der ein Formkörper aus einem Schmelzleitermaterial auf einer keramischen Unterlage aufgebracht und mittels Sandstrahlen zum Teil wieder abgetragen wird. Über das Aufbringen des Schmelzleiterformkörpers auf die Unterlage werden keine Aussagen gemacht.

Es war daher Aufgabe der vorliegenden Erfindung, ein Verfahren zur Herstellung flinker Schmelzsicherungen zu entwickeln, insbesondere für elektronische Baugruppen, bestehend aus einer keramischen Unterlage und einer leichtschmelzenden Metall-oder Legierungsschicht, durch Aufbringen eines Formteils aus diesem Metall bzw. Legierung auf die keramische Unterlage, wobei dieses Verfahren einfach durchführbar sein und zu einer definierten Schmelzleiterzusammensetzung führen sollte.

Diese Aufgabe wird erfindungsgemäß dadurch gelöst, daß dem Metall bzw. der Legierung des Formteils 0,5 bis 10 Gew. % Titan, Zirkonium, Hafnium und/oder Beryllium zugegeben werden und das Formteil auf der keramischen Unterlage unter Vakuum oder Schutzgas aufgeschmolzen wird.

Vorzugsweise setzt man dem Metall bzw. der Legierung 1,5 bis 8 Gew. % Titan, Zirkonium und/oder Beryllium zu.

Durch das erfindungsgemäße Verfahren wird die Herstellung solcher flinker Schmelzsicherungen wesentlich vereinfacht. Vorzugsweise wird eine Folie oder ein Stanzteil aus einem dünnen Band in der gewünschten Geometrie und in der gewünschten Werkstoffzusammensetzung, je nach Ansprechtemperatur bzw. -stromstärke, auf der Keramikunterlage aufgeschmolzen. Diese Unterlage kann beispielsweise aus Aluminiumoxid, Siliziumoxid, Siliziumkarbid, Siliziumnitrid, Aluminiumnitrid oder Glas bestehen. Durch den Zusatz von Titan, Zirkonium, Hafnium und/oder Beryllium zum Schmelzleiterwerkstoff erfolgt eine Benetzung der Keramikunterlage, wodurch eine ausreichende Haftfestigkeit der Schicht erzielt wird. Überraschenderweise werden diese Zusatzmetalle beim Aufschmelzen durch Reaktion mit der Unterlage praktisch vollständig aus der Schmelzleiterschicht entfernt, so daß diese Schicht und damit die Schmelzsicherung optimale physikalische und elektrische Eigenschaften aufweist, die durch Wahl des Werkstoffs zuverlässig eingestellt werden können.

Als Schmelzleiterwerkstoffe haben sich insbesondere Silber, Zinn, Blei, Indium, Silber-Kupfer-Legierungen, Silber-Kupfer-Indium-Legierungen und Zinn-Blei-Legierungen bewährt, denen 0,5 bis 10 Gew. % Titan, Zirkonium, Hafnium und/oder Beryllium zugesetzt werden.

In hybriden Schaltkreisen auf Keramiksubstraten kann die Schmelzsicherung ohne weiteren Lötvorgang direkt mit in die Schaltung einbezogen werden.

## Ansprüche

1. Verfahren zur Herstellung flinker Schmelzsicherungen, insbesondere für elektronische Baugruppen, bestehend aus einer keramischen Unterlage und einer leichtschmelzenden Metall-oder Legierungsschicht, durch Aufbringen eines Formteils aus diesem Metall bzw. dieser Legierung auf die keramische Unterlage,
dadurch gekennzeichnet,
daß dem Metall bzw. der Legierung des Formteils 0,5 bis 10 Gew. % Titan, Zirkonium, Hafnium und/oder Beryllium zugegeben werden, und das Formteil auf der keramischen Unterlage unter Vakuum oder Schutzgas aufgeschmolzen wird.

2. Verfahren zur Herstellung flinker Schmelzsicherungen nach Anspruch 1,
dadurch gekennzeichnet,
daß dem Metall bzw. der Legierung des Formteils 1,5 bis 8 Gew. % Titan, Zirkonium und/oder Beryllium zugesetzt werden.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | DE-A-2 116 828 (RCA CORP.)<br>* Anspruch 1, Seite 1, Absatz 1 - Seite 2, Absatz 3 *<br>--- | 1 | H 01 H 69/02 |
| Y | DE-A-2 055 657 (SIEMENS AG)<br>* Seite 4, Zeile 1 - Seite 5, Absatz 2; Seite 8, Zeile 1 - Seite 9, Absatz 9 *<br>--- | 1 | |
| Y | DE-C-1 126 218 (N.V. PHILIPS'GLOIELAMPENFABRIEKEN)<br>* Spalte 1, Absatz 1; Spalte 1, Zeile 45 - Spalte 3, Zeile 30 *<br>--- | 1 | |
| Y | DE-B-1 030 756 (TELEFUNKEN G.M.B.H.)<br>* Spalte 1, Zeile 1 - Spalte 3, Zeile 9 * | 1 | |
| A | <br>--- | 2 | |
| A | DE-C-1 058 920 (DODUCO)<br>* ganzes Dokument *<br>--- | 1,2 | |
| A | EP-A-0 096 834 (WICKMANN-WERKE GMBH)<br>* Anspruch 10, Figur 1 * & DE - A - 32 21919 (Kat. D,A)<br>--- | 1 | |
| D,A | DE-U-7 826 855 (WICKMANN-WERKE GMBH)<br>* Seite 5, Absatz 1; Figuren 1, 2 *<br>----- | 1 | |

**RECHERCHIERTE SACHGEBIETE (Int. Cl.4)**

H 01 H 69/00
H 01 H 85/00
C 04 B 37/00

Der vorliegende Recherchenbericht wurde für alle Patentansprüche erstellt

| Recherchenort | Abschlußdatum der Recherche | Prüfer |
|---|---|---|
| BERLIN | 16-12-1987 | RUPPERT W |